# EUROPEAN PATENT SPECIFICATION

(11) **EP 0 802 625 B1**
(45) Date of publication and mention of the grant of the patent: **25.06.2003**
(21) Application number: 96302777.6
(22) Date of filing: 19.04.1996
(51) Int. Cl.: H03D 9/06

(54) **Unbalanced fet mixer**
FET-Mischer der nicht in Gegentaktschaltung realisiert ist
Mélangeur à transistor FET non équilibré

(43) Date of publication of application: 22.10.1997
(73) Proprietor: WATKINS-JOHNSON COMPANY, Palo Alto, CA 94304-1223 (US)
(72) Inventor: Li, Xiaohui, San Jose, California 95129 (US); Vice, Michael Wendell, El Granada, California 94018 (US)
(74) Representative: Cross, Rupert Edward Blount

(56) References cited:
- DE-A- 2 816 586
- US-A- 4 949 398
- US-A- 5 060 298
- US-A- 5 263 198
- INTERNATIONAL MICROWAVE SYMPOSIUM, LONG BEACH, JUNE 13 - 15, 1989. VOLUMES 1 - 3 BOUND AS ONE, vol. 1, 13 June 1989, INSTITUTE OF ELECTRICAL AND ELECTRONICS ENGINEERS, pages 1027-1030, XP000077291 CHANG K W ET AL: "ZERO BIAS GAINAS MISFET MIXERS"
- IEEE TRANSACTIONS ON MICROWAVE THEORY AND TECHNIQUES, vol. 35, no. 4, April 1987, NEW YORK US, pages 425-429, XP002006781 S. A. MAAS: "A GaAs MESFET Mixer with Very Low Intermodulation"

## Description

### BACKGROUND OF THE INVENTION

### Field of the Invention

This invention relates generally to radio frequency mixers, and more particularly to mixers requiring reduced local oscillator drive levels and having high third order intercepts.

### Description of the Prior Art

The dynamic range of many prior art microwave front-ends is controlled by the single and two-tone intermodulation levels of the mixers therein. Typical high-performance mixers obtain third order intercept points approximately equal to the local oscillator (LO) power minus the conversion loss plus 10-dB. Trade-offs between LO power levels and third order intercept and one dB compression points are inevitable, even in complex multiple device schemes attempting to improve isolation, bandwidth, and single-tone intermodulation levels.

When the channel of a field-effect transistor (FET) comprises the mixing element, low-distortion mixing has been shown to be possible even at moderate LO power levels. (See, Stephen A. Maas, "A GaAs MESFET Balanced Mixer With Very Low Intermodulation," 1987 IEEE MTT-S Digest, pp,895-896.). Recently, both "single-balanced" and "double-balanced" FET mixers have been designed for operation over relatively wide frequency ranges (e.g., 2-8 GHz). The characterization of a mixer as "single-balanced" indicates that a balun is coupled to one of the mixer ports (e.g., the LO port), while a "double-balanced" mixer includes baluns at two of the three ports. Baluns advantageously improve isolation between mixer ports, but are often realized as bulky, coiled-wire discrete components. When implemented as integrated circuits, baluns tend to require a large wafer area, thus undesirably increasing cost and circuit dimensions.

An alternative approach is described in US Patent No. 5,263,198, which shows an FET mixer having a local oscillator (LO) input port and an RF input port, each having a respective matching network, and an IF filter which provides an IF output from the mixer. A resonant loop comprising a length of transmission line and a DC blocking capacitor is connected between the drain and the gate of the FET. The gate of the FET is also connected to an output of the LO matching network, and the drain to an output of the RF matching network. The source of the FET connects to the IF filter.

The dynamic range of existing FET mixers is a function both of the DC operating characteristics of the FET devices included therein, as well as of the LO drive level. Conventional DC bias techniques, including those involving the application of externally-supplied DC gate voltages, have required substantial LO drive levels in applications requiring significant dynamic range. This has generally required the inclusion of relatively high-power RF amplifiers in the "pumping" circuits used to generate the LO drive signals, often resulting in increased circuit cost and complexity. Hence, there is an interest in reducing the LO drive levels required to be supplied to FET mixers.

### SUMMARY OF THIS INVENTION

According to a first aspect of the present invention, there is provided a mixer comprising: an input port for receiving a local oscillator (LO) input signal; a first transistor having a gate terminal, a drain terminal, and a source terminal, said gate terminal being coupled to said input port, and said drain terminal being coupled to a radio frequency (RF) signal port and an intermediate frequency (IF) signal port; a resonator circuit including an inductor connected in parallel with a first intrinsic capacitance of said first transistor between said gate terminal and said drain terminal, said resonator circuit providing signal isolation between said LO input port and said RF signal port; a diplexer circuit for coupling signal energy of a first frequency between said drain terminal and said RF signal port, and for coupling signal energy of a second frequency between said drain terminal and said IF signal port; and a series resonant circuit connected to said LO input port, said series resonant circuit including an input inductive element and an input intrinsic capacitance of said first transistor.

One advantage provided by an embodiment of this invention is that isolation of the LO port from the other mixer signal ports is achieved without use of a balun. A radio frequency mixer provided in accordance with an embodiment of the present invention is not reliant upon a balun to achieve a high third-order intercept.

Another advantage provided by an embodiment of the present invention is that the mixer is capable of operation in the absence of DC bias.

Yet another advantage provided by an embodiment of this invention is that the resonator circuit improves the third order intercept point by preventing signal energy from being coupled from the mixer signal ports connected to the transistor output port to the transistor control terminal.

A further advantage provided by an embodiment of this invention is that operation over a wide dynamic range at reduced LO drive levels is exhibited.

These and other objects and advantages of this invention will no doubt become obvious to those of ordinary skill in the art after having read the following detailed description of the preferred embodiments which are illustrated in the various drawing figures.

### IN THE DRAWINGS

FIG. 1 is a block diagram of preferred embodiment of the unbalanced mixer of the present invention.

FIG. 2 is a schematic diagram of a preferred embodiment of the unbalanced mixer of this invention.

FIG. 3 shows a schematic diagram of an alternate embodiment of an unbalanced mixer in accordance with the present invention.

FIG. 4 depicts a specific implementation of the mixer of FIG. 3, in which the diodes comprising a clamp circuit are realized using diode-connected field-effect transistors.

### DETAILED DESCRIPTION OF THE PREFERRED EMBODIMENTS

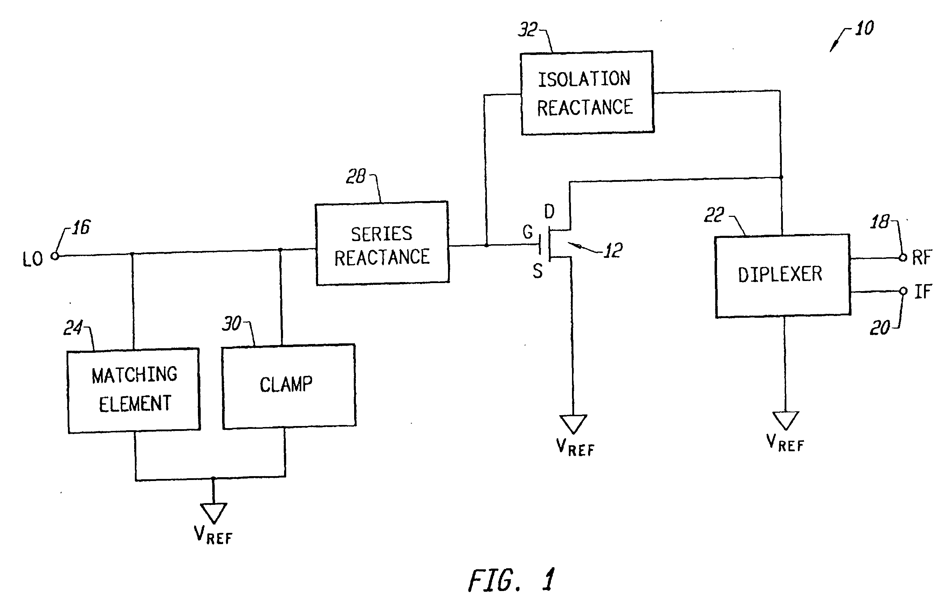

FIG. 1 is a block diagram of a preferred embodiment of the unbalanced mixer 10 of the present invention. The mixer 10 includes a transistor 12, which in an exemplary implementation is realized using a field-effect transistor (FET) having a control or gate (G) terminal, as well as drain (D) and source (S) terminals. The mixer 10 includes a local oscillator (LO) input port 16, to which is applied an LO input signal, and further includes radio frequency (RF) and intermediate frequency (IF) signal ports 18 and 20. A diplexer 22, interposed between the drain (D) and the signal ports 18, 20, functions to couple signal energy between these ports and the drain (D). When the mixer 10 is operational as a frequency upconverter, input signals are applied to the LO and IF ports 20 and an output signal coupled from RF signal port 18. During operation as a frequency downconverter, input signals are applied to the LO and RF ports 16 and 18, and output signal tapped from the IF signal port 20.

Since in an exemplary implementation the LO input port 16 receives the LO input signal over a 50Ω transmission line (not shown), the reactance of a matching element 24 is selected to ensure that the impedance into LO port 16 is also 50Ω. As is indicated by FIG. 1, the LO input signal is coupled to the FET 12 through a series reactance 28. In accordance with one aspect of the invention, the input LO signal is amplified by a series resonator comprised of: (i) an inductive element within the series reactance 28, and (ii) the intrinsic gate-source capacitance (C_{gs}) of the FET 12. The series resonator becomes resonant at the frequency of the LO input signal, and hence reduces the required magnitude of the LO input signal. A clamp circuit 30 prevents negative half-cycles of the amplified LO input signal from causing reverse-breakdown at the transistor gate (G) by clamping the gate voltage to approximately one diode drop below the reference potential V_{REF}.

The mixer 10 further includes an isolation reactance 32 connected between the gate (G) and drain (D) of the transistor 12. In accordance with one aspect of the present invention, an inductive component of the isolation reactance 32 and the intrinsic gate-drain capacitance (C_{gd}) of the transistor 12 form an "isolation resonator", which effectively decouples the transistor gate (G) from the drain (D) at the RF signal frequency. In particular, the isolation resonator approximates an open circuit at the frequency of the signal energy impressed upon the RF output port 18 by the drain (D) through diplexer 22. In addition, a capacitive component within the isolation reactance 32 provides the requisite low-frequency isolation between the IF signal port 20 and the transistor gate (G). In this way the isolation reactance 32 enables the LO port 16 to be isolated from the RF port 18 without utilization of a balun, thereby enabling efficient realization of the mixer 10 as an integrated circuit. The isolation resonator also allows the achievement of a favorable third-order intercept point, since the reverse isolation effected thereby prevents RF and IF signal energy from being coupled to the gate (G) and influencing the conductance of the FET 12.

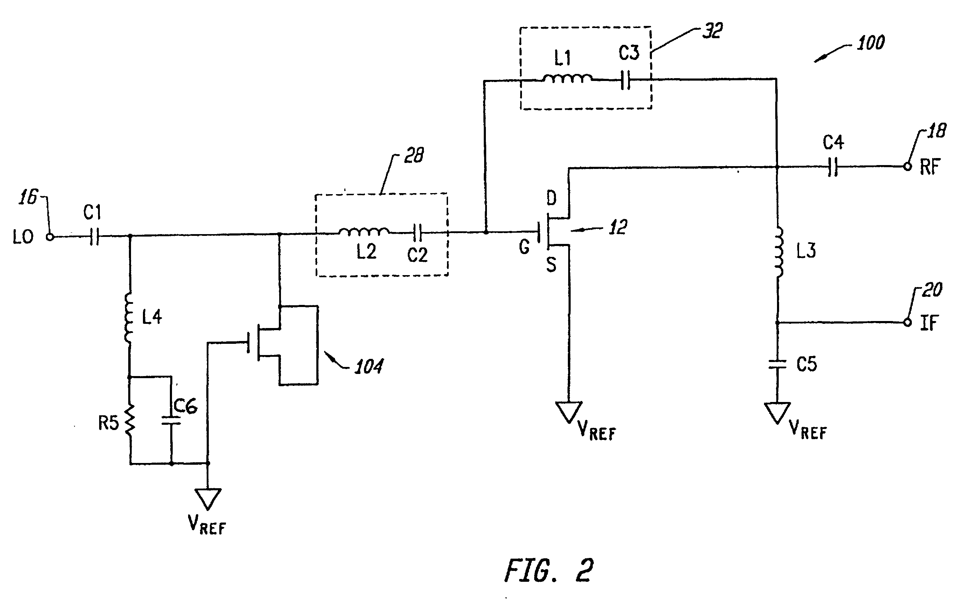

Referring now to FIG. 2, there is shown a schematic diagram of a preferred embodiment of an unbalanced mixer 100 of the present invention. As is indicated by FIG. 2, the diplexer 22 includes capacitors C4 and C5, and an inductor L3. The inductor L3 serves to prevent higher frequency RF signal energy from being coupled from the transistor drain (D) to the IF signal port 20. In the embodiment of FIG. 2, the isolation reactance 32 is seen to be comprised of an inductor L1 in series with a capacitor C3. The inductor L1, in parallel with the intrinsic capacitance C_{gd} of FET 12, together form an isolation resonator. The value of L1 is selected such that the isolation resonator becomes resonant at the frequency of the RF signal energy coupled to the RF port 18 from the drain (D) of FET 12. Capacitor C3 provides isolation between the relatively low-frequency signals appearing at IF port 20 and the gate (G) of FET 12.

The series reactance 28 at the gate (G) of FET 12 is seen to be comprised of an inductor L2 in series with a capacitor C2 The inductor L2, in series with the intrinsic capacitance C_{gs} of FET 12, forms a series resonator designed to amplify the LO input signal applied at the LO input port 16. This advantageously reduces the magnitude of LO input signal necessary to achieve a given level of RF output power when the mixer is configured as a frequency upconverter. When the mixer is configured as a frequency downconverter, the series resonator enhances efficiency by reducing the LO power level required to achieve a desired IF output power. Since a DC bias current is not supplied to the transistor 12, the channel of transistor 12 is controlled only by the amplified LO input signal being applied to the transistor gate (G). The lack of DC bias is permitted by capacitor C2, which functions to allow the transistor 12 to achieve self-bias.

Capacitor C1 is a DC blocking capacitor, which prevents DC offsets at the LO input port 16 from reaching the transistor gate (G). In addition, the capacitor C1 allows the clamping circuit 30 to attain self-bias.

As mentioned above, reverse breakdown at the gate of FET 12 is prevented by clamp circuit 30. In the embodiment of FIG. 2, clamp circuit 30 is comprised of a diode-connected FET 104. In operation, FET 104 appears as a reverse-biased diode during positive half-cycles of the LO signal applied to LO port 16. When the magnitude of negative half-cycles of the LO signal exceed approximately one diode drop (e.g., 0.7V), the diode-connected transistor 104 becomes forward biased and hence clamps the applied LO input signal level. In an exemplary embodiment it has been found that the matching element 24 should exhibit an inductive reactance in order that the impedance into the LO port 16 be approximately 50Ω. Accordingly, in the implementation of FIG. 2 the matching element 24 comprises an inductor L4 in series with a resistor R5 and a parallel capacitor C6.

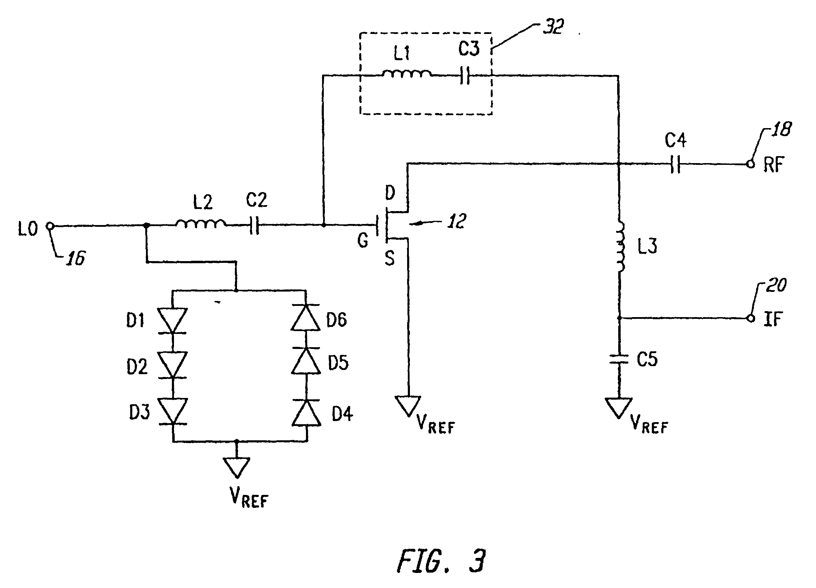

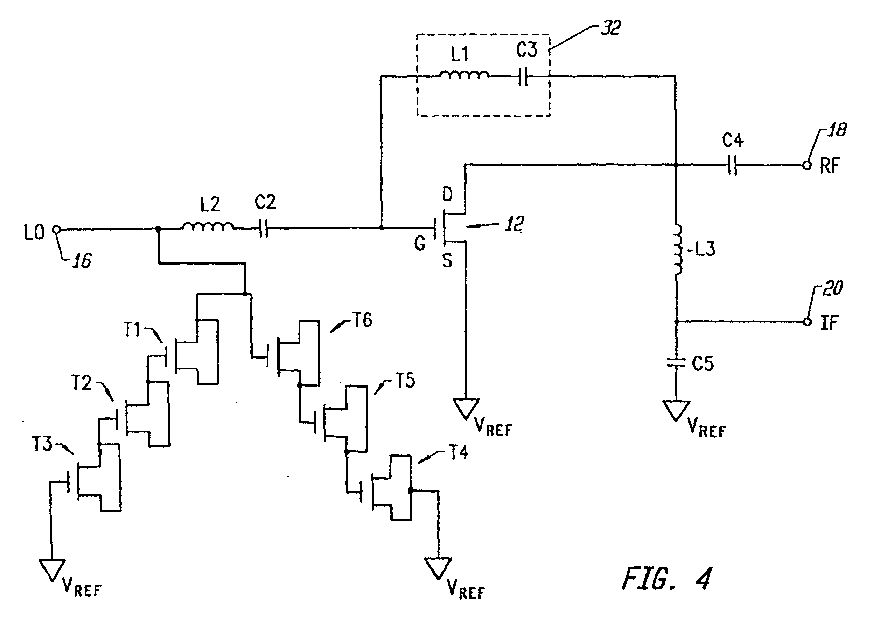

FIG. 3 shows a schematic diagram of an alternate embodiment of an unbalanced mixer in accordance with the present invention. The mixers of FIGS. 2 and 3 are substantially similar, with the exception that the clamp circuit within the mixer of FIG. 3 is realized using parallel chains of series-connected diodes. In particular, the clamp circuit of FIG. 3 includes a first set of series-connected diodes D1-D3, connected in parallel with a second set of series-connected diodes D4-D6. FIG. 4 depicts a specific implementation of the mixer of FIG. 3, in which the diodes D1-D6 are realized using diode-connected field-effect transistors T1-T6.

## Claims

1. A mixer (10), comprising:
an input port (16) for receiving a local oscillator (LO) input signal;
a first transistor (12) having a gate terminal (G), a drain terminal (D), and a source terminal (S), said gate terminal (G) being coupled to said input port (16), and said drain terminal (D) being coupled to a radio frequency (RF) signal port (18) and an intermediate frequency (IF) signal port (20);
a resonator circuit (32) including an inductor (L1) connected in parallel with a first intrinsic capacitance (C_{GD}) of said first transistor (12) between said gate terminal (G) and said drain terminal (D), said resonator circuit providing signal isolation between said LO input port (16) and said RF signal port;
a diplexer circuit (22) for coupling signal energy of a first frequency between said drain terminal (D) and said RF signal port (18), and for coupling signal energy of a second frequency between said drain terminal (D) and said IF signal port (20); and
a series resonant circuit (28) connected to said LO input port (16), said series resonant circuit including an input inductive element (L2) and an input intrinsic capacitance (C_{GS}) of said first transistor (12).

2. The mixer (10) of claim 1 further including a reverse-breakdown prevention circuit (30), connected to said input port (16) of said mixer (10), for preventing said input signal from causing reverse-breakdown at said gate terminal (G) of said first transistor (12).

3. The mixer (10) of claim 2 wherein said reverse-breakdown prevention circuit (30) is connected in parallel with said series resonant circuit at said input port (16) of said mixer (10).

4. The mixer (10) of any preceding claim wherein the mixer (10) is an unbalanced FET mixer (10), and wherein said first transistor (12) comprises an FET transistor (12).

5. The mixer (10) of any preceding claim wherein said diplexer circuit (22) includes inductive (L3) and capacitive (C4, C5) circuit elements.

6. The mixer (10) of any preceding claim wherein said series resonant circuit is resonant at a frequency of said local oscillator signal.

## Patentansprüche

1. Mischstufe (10)
- mit einem Eingangskanal (16) für den Empfang eines Eingangssignals eines Überlagerungsoszillators (LO),
- mit einem ersten Transistor (12), der eine Gate-Klemme (G), eine Drain-Klemme (D) und eine Source-Klemme (S) hat, wobei die Gate-Klemme (G) mit dem Eingangskanal (16), die Drain-Klemme (D) mit einem Signalkanal (18) für Hochfrequenz (RF) und mit einem Signalkanal (20) für eine Zwischenfrequenz (IF) verbunden ist,
- mit einem Schwingkreis (32), der eine Drossel (L1) hat, die parallel zu einem ersten intrinsischen kapazitiven Widerstand (C_{GD}) des ersten Transistors (12) zwischen der Gate-Klemme (G) und der Drain-Klemme (D) geschaltet ist, wobei der Schwingkreis eine Signaltrennung zwischen dem LO-Eingangskanal (16) und dem HF-Signalkanal bereitstellt,
- mit einer Diplexer-Schaltung (22) zum Einkoppeln von Signalenergie mit einer ersten Frequenz zwischen der Drain-Klemme (D) und dem HF-Signalkanal (18) und zum Einkoppeln von Signalenergie mit einer zweiten Frequenz zwischen der Drain-Klemme (D) und dem IF-Signalkanal (20), sowie
- mit einem Serienresonanzkreis (28), der mit dem LO-Eingangskanal (16) verbunden ist, wobei der Serienresonanzkreis ein induktives Eingangselement (L2) und einen intrinsischen kapazitiven Eingangswiderstand (C_{GS}) des ersten Transistors (12) hat.

2. Mischstufe (10) nach Anspruch 1, welche weiterhin eine Schaltung (30) zur Verhinderung eines Rückwärtsdurchbruchs aufweist, die mit dem Eingangskanal (16) der Mischstufe (10) verbunden ist, um zu verhindern, dass das Eingangssignal einen Rückwärtsdurchbruch an der Gate-Klemme (G) des ersten Transistors (12) verursacht.

3. Mischstufe (10) nach Anspruch 2, bei welcher die Schaltung (30) zur Verhinderung eines Rückwärtsdurchbruchs parallel zu dem Serienresonanzkreis an dem Eingangskanal (16) der Mischstufe (10) geschaltet ist.

4. Mischstufe (10) nach einem vorhergehenden Anspruch, bei welcher die Mischstufe (10) eine unsymmetrische FET-Mischstufe (10) ist und der erste Transistor (12) einen FET-Transistor (12) umfasst.

5. Mischstufe (10) nach einem vorhergehenden Anspruch, bei welchem die Diplexer-Schaltung (22) induktive Schaltungselemente (L3) und kapazitive Schaltungselemente (C4, C5) aufweist.

6. Mischstufe (10) nach einem der vorhergehenden Anspruch, bei welcher sich der Serienresonanzkreis bei einer Frequenz des Überlagerungsoszillatorsignals in Resonanz befindet.

## Revendications

1. Mélangeur (10), comportant :
un accès d'entrée (16) destiné à recevoir un signal d'entrée d'un oscillateur local (LO) ;
un premier transistor (12) ayant une borné de grille (G), une borne de drain (D) et une borne de source (S), ladite borne de grille (G) étant couplée audit accès d'entrée (16), et ladite borne de drain (D) étant couplée à un accès (18) de signal radiofréquence (RF) et à un accès (20) de signal de fréquence intermédiaire (IF) ;
un circuit de résonateur (32) comprenant une inductance (L1) contenant en parallèle avec une première capacité intrinsèque (C_{GD}) dudit premier transistor (12) entre ladite borne de grille (G) et ladite borne de drain (D), ledit circuit de résonateur établissant un isolement de signal entre ledit accès d'entrée LO (16) et ledit accès de signal RF ;
un circuit diplexeur (22) destiné à coupler ladite énergie de signal d'une première fréquence entre ladite borne de drain (D) et ledit accès de signal RF (18), et à coupler une énergie de signal d'une seconde fréquence entre ladite borne de drain (D) et ledit accès de signal IF (20) ; et
un circuit résonnant série (28) connecté audit accès d'entrée LO (16), ledit circuit résonnant série comprenant un élément inductif d'entrée (L2) et une capacité intrinsèque d'entrée (C_{GS}) dudit premier transistor (12).

2. Mélangeur (10) selon la revendication 1, comprenant en outre un circuit (30) de prévention de claquage inverse, connecté audit accès d'entrée (16) dudit mélangeur (10), pour empêcher ledit signal d'entrée de provoquer un claquage inverse à ladite borne de grille (G) dudit premier transistor (12).

3. Mélangeur (10) selon la revendication 2, dans lequel ledit circuit (30) de prévention de claquage inverse est connecté en parallèle avec ledit circuit résonnant série audit accès d'entrée (16) dudit mélangeur (10).

4. Mélangeur (10) selon l'une quelconque des revendications précédentes, dans lequel le mélangeur (10) est un mélangeur (10) à FET non équilibré, et dans lequel ledit premier transistor (12) comprend un transistor FET (12).

5. Mélangeur (10) selon l'une quelconque des revendications précédentes, dans lequel ledit circuit diplexeur (22) comprend des éléments de circuit inductif (L3) et capacitifs (C4, C5).

6. Mélangeur (10) selon l'une quelconque des revendications précédentes, dans lequel ledit circuit résonnant série est résonnant à une fréquence dudit signal de l'oscillateur local.
